(19) **Europäisches Patentamt European Patent Office Office européen des brevets**

(11) **EP 4 510 460 A1**

(12) **DEMANDE DE BREVET EUROPEEN**

(43) Date de publication:
**19.02.2025 Bulletin 2025/08**

(21) Numéro de dépôt: **24194943.7**

(22) Date de dépôt: **16.08.2024**

(51) Classification Internationale des Brevets (IPC):
*H04B 1/717* (2011.01)    *H04B 1/7163* (2011.01)
*H03C 5/00* (2006.01)    *H04L 27/12* (2006.01)
*H03B 5/12* (2006.01)    *H04L 27/32* (2006.01)
*H03B 5/18* (2006.01)    *H03K 7/10* (2006.01)

(52) Classification Coopérative des Brevets (CPC):
**H04B 1/7174; H03C 5/00; H04B 1/71635; H04L 27/127;** H03K 7/10

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **18.08.2023 FR 2308774**

(71) Demandeur: **Commissariat à l'Energie Atomique et aux Energies Alternatives**
**75015 Paris (FR)**

(72) Inventeur: **DEPARIS, Nicolas**
**38570 TENCIN (FR)**

(74) Mandataire: **Lavoix**
**2, place d'Estienne d'Orves**
**75441 Paris Cedex 09 (FR)**

(54) **GÉNÉRATEUR ÉLECTRONIQUE DE SIGNAUX IMPULSIONNELS SOUS PORTEUSE MODULÉE ET ÉMETTEUR DE SIGNAUX RADIOFRÉQUENCE ASSOCIÉ**

(57) Ce générateur électronique de signaux impulsionnels sous porteuse modulée comporte un module (15) de modulation d'un train d'impulsions dont la position et l'amplitude sont commandables, formant un signal de commutation ($S_3$); un module (16) de commutation, connecté en sortie du module (15) de modulation d'un train impulsions, comportant au moins un transistor (22), commandé par ledit signal de commutation ($S_3$), un oscillateur (18) à verrouillage de fréquence commandé en tension, ayant une bande de verrouillage en fréquence autour d'une fréquence d'oscillation libre contrôlée par une tension de contrôle, connecté en sortie du module de commutation (16), le module de commutation permettant l'injection d'un signal impulsionnel périodique ($S_4$) ayant un spectre fréquentiel comportant au moins une raie de fréquence dans ladite bande de verrouillage en fréquence. Cet agencement permet d'obtenir en sortie de l'oscillateur des signaux impulsionnels ($S_5$) sous porteuse modulée contrôlés en fréquence, en phase et en amplitude.

FIG.1

**Description**

La présente invention concerne un générateur électronique de signaux impulsionnels sous porteuse modulée et un émetteur de signaux radiofréquence associé.

L'invention se situe dans le domaine de la génération de signaux ultra large bande impulsionnels sous porteuse modulée en phase et en amplitude.

Elle trouve de nombreuses applications, en particulier dans les télécommunications à haut débit, dans les télécommunications à faible consommation, en particulier dans les radars impulsionnels à faible consommation, dans le domaine de la localisation d'objets, dans le domaine des capteurs auto-alimentés, dans le domaine des capteurs radiofréquence.

Dans l'état de la technique, on connaît des systèmes de modulation ultra large bande impulsionnels, notamment utilisant la modulation en position d'impulsion ou PPM (pour « Pulse Position Modulation » en anglais), la modulation d'amplitude tout ou rien OOK (pour « On Off Keying » en anglais), les modulations vectorielles QAM (pour « quadrature amplitude modulation ») ou une combinaison de ces modulations. Les modulations vectorielles QAM, comme la modulation BPSK (pour «Binary phase-shift keying» en anglais) par exemple, nécessitent la génération d'un signal de référence, la porteuse, avec des contraintes importantes en terme de bruit de phase. Une des limitations de ces techniques de modulation vectorielle impulsionnelle réside entre autres dans la complexité et la consommation électrique des blocs de génération du signal de référence, la porteuse, et des blocs de modulation.

La plupart des générateurs directs de signaux ultra large bande impulsionnels synthétisent la fréquence porteuse à l'aide d'un bloc de type boucle à verrouillage de phase ou PLL (pour « Phase-Locked Loop »), qui est un dispositif électronique permettant d'asservir la phase ou la fréquence de sortie en fonction de la phase ou de la fréquence d'un signal d'entrée de référence. Ce signal synthétisé nécessite des blocs de modulations complexes pour garantir la génération d'un signal d'enveloppe impulsionnel avec une modulation vectorielle. Pour synthétiser des fréquences de porteuses élevées, de plusieurs dizaines de GHz, il est nécessaire de mettre au point des PLL complexes, de consommation électrique et de taille importantes. De plus, un des objectifs à atteindre est de réduire le bruit de phase des signaux de sortie.

L'invention a pour objet de remédier aux inconvénients de l'état de la technique précités.

A cet effet, l'invention propose, selon un aspect, un générateur électronique de signaux impulsionnels sous porteuse modulée comportant :

- un module de modulation d'un train d'impulsions dont la position et l'amplitude sont commandables, formant un signal de commutation;

- un module de commutation, connecté en sortie du module de modulation d'un train impulsions, comportant au moins un transistor, dont la commutation est commandée par ledit signal de commutation,
- un oscillateur à verrouillage de fréquence commandé en tension, ayant une bande de verrouillage en fréquence autour d'une fréquence d'oscillation libre contrôlée par une tension de contrôle, l'oscillateur étant connecté en sortie du module de commutation, le module de commutation fournissant un signal impulsionnel périodique, ledit signal périodique impulsionnel étant injecté dans l'oscillateur,
- le signal impulsionnel périodique ayant un spectre fréquentiel comportant au moins une raie de fréquence dans ladite bande de verrouillage en fréquence, l'agencement desdits modules permettant d'obtenir en sortie de l'oscillateur des signaux impulsionnels sous porteuse modulée contrôlés en fréquence, en phase et en amplitude.

Avantageusement, le générateur proposé permet de réaliser une génération directe de signaux impulsionnels sous porteuse modulée, verrouillée par injection pulsée, contrôlée en fréquence, en phase, en amplitude et en largeur d'impulsion, sans utiliser de boucle à verrouillage de phase.

Le générateur électronique de signaux impulsionnels sous porteuse modulée selon l'invention peut également présenter une ou plusieurs des caractéristiques ci-dessous, prises indépendamment ou selon toutes les combinaisons techniquement envisageables.

Le module de modulation d'un train d'impulsions comprend un générateur d'impulsions répétées périodiquement formant un signal d'entrée, connecté en entrée d'un module de retard configuré pour introduire des retards programmables de manière à générer un signal modulé en position, ledit signal modulé en position étant fourni en entrée d'un module de génération de signaux de commutation, commandé par un signal de tension.

Les signaux impulsionnels sous porteuse modulée sont en outre contrôlés en largeur d'impulsion en fonction dudit signal d'entrée.

Le module de retard configuré pour introduire des retards programmables est un module convertisseur tension-temps ou courant-temps.

Le module de génération de signaux de commutation comprend au moins un composant d'amplification de signaux électriques à temps de commutation très court, d'amplitude commandée par ledit signal de tension.

Le module de génération de signaux de commutation comprend un nombre N d'inverseurs à transistors connectés en série.

Chacun desdits module de modulation, module de commutation et l'oscillateur est réalisé sous forme de composants CMOS.

Selon un autre aspect, l'invention concerne un émetteur de signaux radiofréquence comportant un générateur électronique de signaux impulsionnels sous porteuse modulée tel que brièvement introduit et une antenne d'émission connectée audit générateur électronique de signaux impulsionnels sous porteuse modulée.

Selon une caractéristique, l'émetteur de signaux radiofréquence comporte en outre un amplificateur de puissance connecté entre la sortie dudit générateur électronique de signaux impulsionnels sous porteuse modulée et ladite antenne d'émission.

D'autres caractéristiques et avantages de l'invention ressortiront de la description qui en est donnée ci-dessous, à titre indicatif et nullement limitatif, en référence aux figures annexées, parmi lesquelles :

- la figure 1 est un schéma-bloc d'un émetteur de signaux radiofréquence comportant un générateur électronique de signaux impulsionnels sous porteuse modulée selon un mode de réalisation de l'invention ;
- la figure 2 représente schématiquement une forme d'onde de signal impulsionnel sous porteuse généré ;
- la figure 3 représente schématiquement un mode de réalisation d'un générateur électronique de signaux impulsionnels sous porteuse modulée.

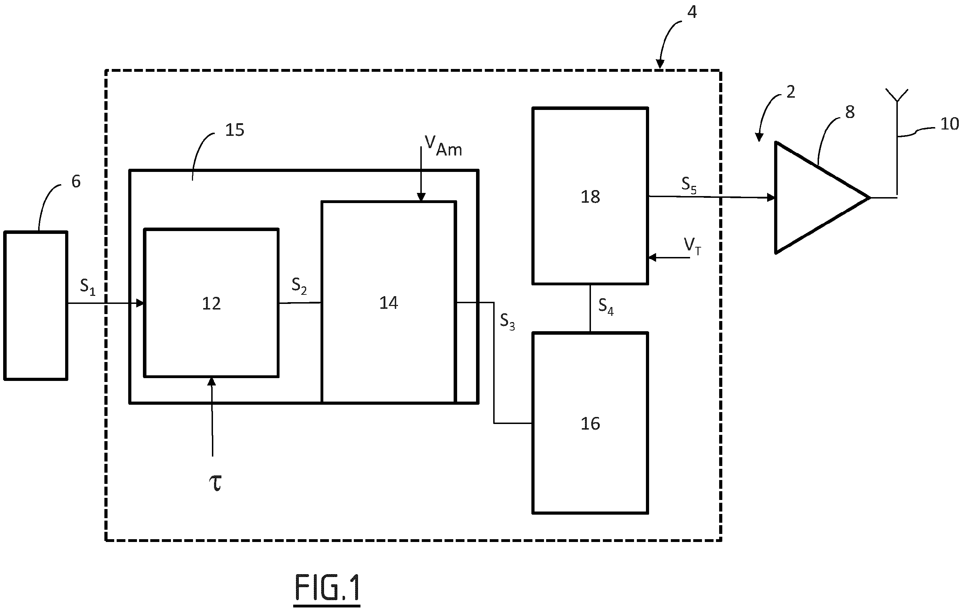

La **figure 1** représente schématiquement un émetteur de signaux radiofréquence 2 comportant un générateur électronique 4 de signaux impulsionnels sous porteuse modulée, dont l'entrée est connectée à un générateur d'impulsions 6 et dont la sortie est connectée à un amplificateur de puissance 8 et à une antenne d'émission 10.

L'amplificateur de puissance est optionnel, il peut ne pas être présent dans des variantes de réalisation.

Selon une variante, le générateur d'impulsions 6 est intégré dans le générateur électronique 4 de signaux impulsionnels sous porteuse modulée.

Le générateur d'impulsions 6 fournit un signal d'entrée périodique $S_1$, formé de trains d'impulsions répétés périodiquement, avec une période de répétition d'impulsion PRP=1/PRF où PRF est la fréquence de répétition des impulsions.

Le générateur électronique 4 de signaux impulsionnels sous porteuse modulée, appelé générateur 4 par la suite, comporte :

- un module 15 module de modulation d'un train d'impulsions formant un signal de commutation $S_3$, dont la position et l'amplitude sont commandables ; le module 15 comporte, dans le mode de réalisation illustré, un module 12 de retard configuré pour introduire des retards programmables sur le signal d'entrée $S_1$, générant en sortie un signal modulé en position $S_2$, et un module 14 de génération de signaux de commutation, d'amplitude en tension contrôlée par un signal $V_{Am}$, recevant en entrée le signal modulé en position $S_2$ ;

- un module 16 de commutation, connecté en sortie du module 15, comportant au moins un transistor, dont la commutation est commandée par le signal de commutation $S_3$, le module 16 de commutation permettant l'injection, en entrée d'un oscillateur 18, d'un signal composé du signal impulsionnel périodique modulé $S_4$ ;

- un module 18 d'oscillation, composé d'un seul oscillateur 18, ayant une fréquence libre d'oscillation contrôlée par une tension de contrôle $V_T$, connecté en sortie du module de commutation 16. Un tel oscillateur est également connu sous le nom de VCO (pour « Voltage-Controlled Oscillator »). L'oscillateur 18 a une bande de verrouillage en fréquence autour de sa fréquence d'oscillation libre.

Le signal impulsionnel périodique modulé $S_4$ a un spectre fréquentiel comportant au moins une raie de fréquence dans la bande de verrouillage en fréquence de l'oscillateur 18.

Ainsi, avantageusement, les temps de commutation dans le module de commutation 16, commandés par le module 14, assurent des transitions les plus courtes possibles afin de générer un spectre de raies dont à minima une des raies est présente avec suffisamment d'énergie pour assurer le verrouillage dans la bande de verrouillage en fréquence de l'oscillateur 18.

En sortie de l'oscillateur 18 sont obtenus des signaux impulsionnels sous porteuse $S_5$, comportant les caractéristiques suivantes :

- une phase relative contrôlée par le signal de retard $\tau$ du module 12,
- une amplitude contrôlée par le signal $V_{Am}$ du module 14,
- une fréquence de verrouillage et une phase contrôlée par le signal $V_T$ de l'oscillateur,
- une largeur d'impulsion contrôlée par le signal impulsionnel du signal d'entrée $S_1$.

L'agencement desdits modules permet d'obtenir des signaux impulsionnels sous porteuse modulée, contrôlés en fréquence, en position (ou en phase), en largeur et en amplitude.

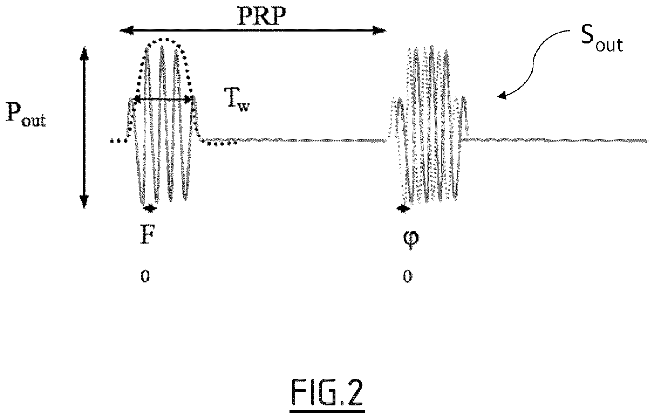

La **figure 2** illustre un exemple de signal impulsionnel sous porteuse en fonction du temps. En d'autres termes, la figure 2 illustre un exemple de forme d'onde générée.

Le signal impulsionnel $S_5$ sous porteuse modulée est caractérisé par :

- sa puissance $P_{out}$, soit indirectement son amplitude,
- sa fréquence centrale $F_0$ qui est un sous-multiple entier de la fréquence de répétition des impulsions du signal $S_1$,

- la phase relative à l'impulsion précédente $\varphi_0$,
- la largeur à mi-hauteur de l'enveloppe Tw,
- la période de répétition PRP.

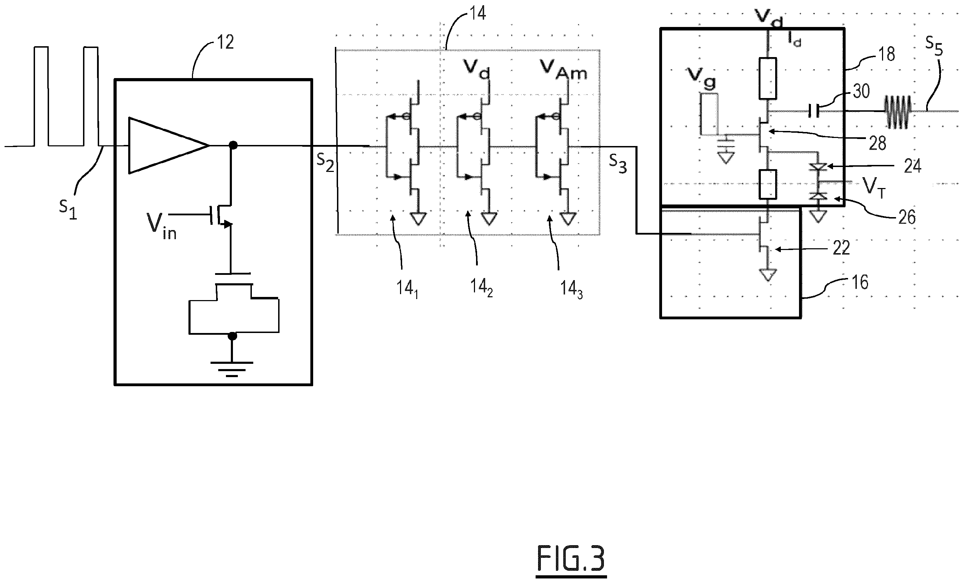

La **figure 3** illustre un mode de réalisation d'un générateur 6, dans lequel les modules 12, 14, 16, 18 sont implémentés avec des composants électroniques selon la technologie CMOS (pour « Complementary Metal Oxide Semi-Conductor »).

Le module 12 est adapté pour introduire des retards $\tau_m$ (t) programmables.

Dans le mode de réalisation illustré, le module 12 est réalisé par un circuit retardateur qui réalise une conversion tension-temps, à partir du signal de tension $V_{in}$, par exemple implémenté en utilisant un circuit à condensateur « shunt » (en anglais « shunt capacitor »).

Bien entendu, tout autre circuit retardateur commandable est utilisable, par exemple un circuit de retard à appauvrissement de courant (en anglais « current starved »), ou un circuit à résistance variable.

Les signaux de retards agissent comme signaux de contrôle permettant de définir avec une grande granularité l'instant de démarrage de l'oscillateur 18.

Dans un mode de réalisation, le module de retard 12 est contrôlé par trois signaux de retards (ou signaux de contrôle), correspondant respectivement à des déphasages de 45°, 90° et 180° pour un signal de référence sinusoïdal, par exemple de fréquence égale à 60 GHz.

En sortie du module 12 de retard est obtenu un signal $S_2$ modulé en position (PPM), ce qui se traduit par une modulation de phase dans le signal impulsionnel sous porteuse modulée $S_5$.

Le signal $S_2$ est transmis en entrée du module 14 de génération de signaux de commutation $S_3$, l'amplitude du signal de sortie de ce module étant contrôlée par une tension $V_{Am}$.

Dans un mode de réalisation, le module 14 est réalisé par un nombre N d'inverseurs connectés en série, N étant égal à 3 dans l'exemple. Le module 14 comprend N=3 inverseurs $14_1$, $14_2$ et $14_3$ à transistors, qui présentent l'avantage d'avoir des temps de commutation courts, par exemple inférieur à 10 picosecondes en technologie CMOS 65nm SOI.

Bien entendu, l'invention s'applique avec un nombre N quelconque d'inverseurs, différent du nombre d'inverseurs dans l'exemple illustré.

Les transistors des inverseurs $14_1$, $14_2$ et $14_3$ sont dimensionnés en fonction de la bande de verrouillage en fréquence de l'oscillateur 18 et de la fréquence libre d'oscillation de l'oscillateur 18, afin de permettre la commutation du module 16, en front montant, avec le temps de commutation le plus faible possible. A titre d'exemple, le temps de commutation du module 16 est inférieur à 10 picosecondes pour une fréquence libre d'oscillation de 60 GHz.

En effet, l'utilisation d'un nombre N d'inverseurs en série permet asymptotiquement d'obtenir des temps de transition, et plus particulièrement de montée, les plus courts.

Si le nombre N d'inverseurs est pair, le signal impulsionnel $S_5$ en sortie du générateur 6 démarre sur un front montant du signal d'entrée $S_1$. Si le nombre N d'inverseurs est impair, le signal impulsionnel $S_5$ en sortie du générateur 6 démarre sur un front descendant du signal d'entrée $S_1$.

Le signal de commutation $S_3$ obtenu en sortie du module 14 est fourni en entrée du module de commutation 16, qui réalise une commutation entre un mode bloqué (« off ») et un mode passant (« on »).

Lorsque le signal de commutation $S_3$ est à l'état bas (0V par convention), aucun courant ne circule dans le module 16. Lorsque le signal de commutation $S_3$ passe à l'état haut (tension égale à $V_{Am}$ par convention), le module 16 devient passant, un courant circule vers le module d'oscillation 18. Ce courant comporte le courant impulsionnel contrôlé en amplitude, noté $S_4$, riche en harmoniques du signal d'entrée $S_1$.

Dans le mode de réalisation de la figure 3, le module 16 de commutation est composé d'un transistor 22. Plus généralement, le module 16 de commutation comporte au moins un transistor.

La tension de commande sur la grille du transistor 22 permet de contrôler le courant injecté dans la branche principale de l'oscillateur 18, et ainsi de contrôler la puissance de sortie de cet oscillateur et de favoriser le verrouillage par injection.

La tension d'alimentation $V_{Am}$ du module 14 permet de contrôler la tension de commande sur la grille du transistor 22. Ainsi, la tension d'alimentation $V_{Am}$ permet de contrôler la puissance de sortie de cet oscillateur.

La tension d'alimentation $V_{Am}$ du module 14 correspond dans un mode de réalisation à la tension d'alimentation du dernier inverseur, qui est l'inverseur $14_3$ dans l'exemple illustré. Plus généralement, la tension $V_{Am}$ est la tension d'alimentation d'au moins le dernier inverseur des N inverseurs, les inverseurs précédent le dernier inverseur pouvant également être alimentés par cette tension.

L'oscillateur 18 comprend des diodes à capacité variable 24, 26, également appelée diodes varactor ou varicap, pilotées par la tension de contrôle $V_T$, un transistor à effet de champ 28 et un condensateur 30.

La fréquence libre d'oscillation f0 de l'oscillateur 18 est fonction de la tension de contrôle $V_T$. Une modulation de la tension appliquée autour de la tension de contrôle modifie la phase instantanée de la fréquence centrale de sortie. Par exemple, dans un exemple d'implémentation, la fréquence moyenne centrale est comprise entre 55 et 65 GHz.

Le signal impulsionnel $S_4$ et la tension de contrôle $V_T$ permettent d'opérer un verrouillage de la fréquence de sortie de l'oscillateur 18 sur un multiple entier de la fréquence du signal d'entrée $S_1$. Ce phénomène est connu sous le nom de verrouillage par injection d'un oscillateur.

Un oscillateur de ce type démarre d'une faible énergie issue d'une composante harmonique présente dans sa bande de verrouillage en fréquence ΔF, proche de sa fréquence libre d'oscillation $f_0$.

Le phénomène de verrouillage est transitoire et dépend fortement du coefficient de qualité externe de l'oscillateur $Q_{ext}$, de la puissance de l'oscillateur $P_{osc}$ et de la puissance du signal $S_4$ injecté, notée $P_{inj}$.

La bande de verrouillage est définie par la formule d'Adler :

$$\Delta F = \frac{f_0}{2 Q_{ext}} \sqrt{\frac{P_{inj}}{P_{osc}}}$$

Lors de l'allumage, en régime transitoire, les deux puissances $P_{osc}(t)$ et $P_{inj}(t)$ sont fonction du temps.

Initialement, la puissance de l'oscillateur $P_{osc}(t)$ est largement inférieure à la puissance du signal injecté, $P_{inj}(t)$, et la bande de verrouillage est grande.

En régime établi, la puissance de l'oscillateur $P_{osc}(t)$ est supérieure à la puissance du signal injecté, $P_{inj}(t)$, la bande de verrouillage diminue. Afin d'assurer que l'oscillateur est verrouillé, en d'autres termes afin d'assurer la présence d'une composante harmonique dans la bande de verrouillage de l'oscillateur, la tension de contrôle $V_T$ est appliquée pour moduler la fréquence $f_0$.

Avantageusement, la consommation d'énergie électrique d'un générateur électronique de signaux impulsionnels sous porteuse modulée tel que décrit est faible. Lorsque l'oscillateur n'est pas en fonctionnement, seul un courant de fuite, de faible amplitude, circule.

Lorsque la technologie CMOS est utilisée, la consommation du générateur est fonction du taux de répétition des impulsions et de la consommation de l'oscillateur.

Par exemple, pour une puissance crête d'émission de $P_{out}$=10mW (10dBm) et un rendement énergétique η=20% (soit une consommation statique de l'oscillateur de 50 mW), si l'impulsion RF est allumée pendant $T_{ON}$=500 ps (soit 30 périodes pour une porteuse à 60 GHz et une bande passante occupée de 4 GHz), l'énergie consommée par impulsion RF est de 50 mWx300 ps=15 pJ.

Avantageusement, l'invention permet un allumage rapide et contrôlé dans le temps d'un module d'oscillation à l'aide d'impulsions à faibles temps de transitions.

Avantageusement, le retard programmable introduit permet de déterminer l'instant de démarrage de l'oscillateur.

Avantageusement, dans le générateur électronique de signaux impulsionnels sous porteuse décrit, les conditions initiales de démarrage de l'oscillateur, notamment l'instant de démarrage, sont déterminées avant la synthèse de fréquence.

Avantageusement, la tension de contrôle $V_T$ appliquée permet de contrôler la phase lors du démarrage de l'oscillateur.

Avantageusement, le générateur électronique de signaux impulsionnels sous porteuse modulée permet de réaliser une modulation en phase n-PSK, en amplitude n-AM et/ou conjointe en phase et amplitude n-QAM, avec un nombre d'états de phase par exemple compris entre 2 et 16.

**Revendications**

1. Générateur électronique de signaux impulsionnels sous porteuse modulée, **caractérisé en ce qu'**il comporte :

   - un module (15) de modulation d'un train d'impulsions dont la position et l'amplitude sont commandables, formant un signal de commutation ($S_3$);
   - un module (16) de commutation, connecté en sortie du module (15) de modulation d'un train impulsions, comportant au moins un transistor (22), dont la commutation est commandée par ledit signal de commutation ($S_3$),
   - un oscillateur (18) à verrouillage de fréquence commandé en tension, ayant une bande de verrouillage en fréquence autour d'une fréquence d'oscillation libre contrôlée par une tension de contrôle, l'oscillateur (18) étant connecté en sortie du module de commutation (16), le module de commutation (16) fournissant un signal impulsionnel périodique ($S_4$), ledit signal périodique impulsionnel ($S_4$) étant injecté dans ledit oscillateur (18),
   - le signal impulsionnel périodique ($S_4$) ayant un spectre fréquentiel comportant au moins une raie de fréquence dans ladite bande de verrouillage en fréquence, l'agencement desdits modules permettant d'obtenir en sortie de l"oscillateur (18) des signaux impulsionnels ($S_5$) sous porteuse modulée contrôlés en fréquence, en phase et en amplitude.

2. Générateur selon la revendication 1, dans lequel le module (15) de modulation d'un train d'impulsions comprend un générateur (6) d'impulsions répétées périodiquement formant un signal d'entrée ($S_1$), connecté en entrée d'un module (12) de retard configuré pour introduire des retards programmables de manière à générer un signal ($S_2$) modulé en position, ledit signal modulé en position ($S_2$) étant fourni en entrée d'un module (14) de génération de signaux de commutation ($S_3$), commandé par un signal de tension ($V_{Am}$).

3. Générateur selon la revendication 2, dans lequel

lesdits signaux impulsionnels ($S_5$) sous porteuse modulée sont en outre contrôlés en largeur d'impulsion en fonction dudit signal d'entrée ($S_1$).

4. Générateur selon l'une quelconque des revendications 2 ou 3, dans lequel le module (12) de retard configuré pour introduire des retards programmables est un module convertisseur tension-temps ou courant-temps.

5. Générateur selon l'une quelconque des revendications 2 à 4, dans lequel le module (14) de génération de signaux de commutation ($S_3$) comprend au moins un composant d'amplification de signaux électriques à temps de commutation très court, d'amplitude commandée par ledit signal de tension ($V_{Am}$).

6. Générateur selon la revendication 5, dans lequel ledit module (14) de génération de signaux de commutation comprend un nombre N d'inverseurs à transistors ($14_1$, $14_2$, $14_3$) connectés en série.

7. Générateur électronique selon l'une quelconque des revendications 1 à 6, dans lequel chacun desdits module (15) de modulation, module (16) de commutation et oscillateur (18) est réalisé sous forme de composants CMOS.

8. Emetteur de signaux radiofréquence comportant un générateur électronique de signaux impulsionnels sous porteuse modulée (4) conforme aux revendications 1 à 7 et une antenne d'émission (10) connectée audit générateur électronique de signaux impulsionnels sous porteuse modulée (4).

9. Emetteur de signaux radiofréquence selon la revendication 8, comportant en outre un amplificateur de puissance (8) connecté entre la sortie dudit générateur électronique de signaux impulsionnels sous porteuse modulée (4) et ladite antenne d'émission (10).

FIG.1

FIG.2

FIG.3

EP 4 510 460 A1

Europäisches Patentamt

European Patent Office

Office européen des brevets

# RAPPORT DE RECHERCHE EUROPEENNE

Numéro de la demande

EP 24 19 4943

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | NICOLAS DEPARIS ET AL: "A 2 pJ/bit pulsed ILO UWB transmitter at 60 GHz in 65-nm CMOS-SOI", ULTRA-WIDEBAND, 2009. ICUWB 2009. IEEE INTERNATIONAL CONFERENCE ON, IEEE, PISCATAWAY, NJ, USA, 9 septembre 2009 (2009-09-09), pages 113-117, XP031547668, ISBN: 978-1-4244-2930-1 * le document en entier * | 1-9 | INV. H04B1/717 H04B1/7163 H03C5/00 H04L27/12 H03B5/12 H04L27/32 H03B5/18 ADD. H03K7/10 |
| Y | US 2010/188253 A1 (SHEARER ERIC S [GB]) 29 juillet 2010 (2010-07-29) * le document en entier * | 1-9 | |
| A | EP 3 799 300 A1 (COMMISSARIAT ENERGIE ATOMIQUE [FR]) 31 mars 2021 (2021-03-31) * alinéa [0033] - alinéa [0075] * * figures 1-11 * | 1-9 | |
| A | DEPARIS N ET AL: "UWB in Millimeter Wave Band With Pulsed ILO", IEEE TRANSACTIONS ON CIRCUITS AND SYSTEMS II: EXPRESS BRIEFS, IEEE, USA, vol. 55, no. 4, 1 avril 2008 (2008-04-01), pages 339-343, XP011333856, ISSN: 1549-7747, DOI: 10.1109/TCSII.2008.918977 * le document en entier * | 1-9 | DOMAINES TECHNIQUES RECHERCHES (IPC) H04B H04L H03D H03B H03K H03C |

-/--

Le présent rapport a été établi pour toutes les revendications

| Lieu de la recherche | Date d'achèvement de la recherche | Examinateur |
|---|---|---|
| Munich | 6 janvier 2025 | Gardella, Simone |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

page 1 de 2

Europäisches
Patentamt

European
Patent Office

Office européen
des brevets

# RAPPORT DE RECHERCHE EUROPEENNE

Numéro de la demande

EP 24 19 4943

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | YUNLIANG ZHU ET AL: "Distributed Waveform Generator: A New Circuit Technique for Ultra-Wideband Pulse Generation, Shaping and Modulation", IEEE JOURNAL OF SOLID-STATE CIRCUITS, IEEE, USA, vol. 44, no. 3, 1 mars 2009 (2009-03-01), pages 808-823, XP011252582, ISSN: 0018-9200, DOI: 10.1109/JSSC.2009.2013770 * III. Distributed Waveform Generator * ----- | 1-9 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| Munich | 6 janvier 2025 | Gardella, Simone |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
...................................................................................
& : membre de la même famille, document correspondant

EPO FORM 1503 03.82 (P04C02)

page 2 de 2

## ANNEXE AU RAPPORT DE RECHERCHE EUROPEENNE
## RELATIF A LA DEMANDE DE BREVET EUROPEEN NO.

EP 24 19 4943

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-01-2025

| Document brevet cité au rapport de recherche | Date de publication | Membre(s) de la famille de brevet(s) | | Date de publication |
|---|---|---|---|---|
| US 2010188253 A1 | 29-07-2010 | EP | 2165219 A1 | 24-03-2010 |
| | | MY | 159889 A | 15-02-2017 |
| | | US | 2010188253 A1 | 29-07-2010 |
| | | WO | 2009008862 A1 | 15-01-2009 |
| EP 3799300 A1 | 31-03-2021 | EP | 3799300 A1 | 31-03-2021 |
| | | EP | 3799301 A1 | 31-03-2021 |
| | | FR | 3101213 A1 | 26-03-2021 |
| | | US | 2021091758 A1 | 25-03-2021 |

EPO FORM P0460

Pour tout renseignement concernant cette annexe : voir Journal Officiel de l'Office européen des brevets, No.12/82